Europäisches Patentamt

European Patent Office

Office européen des brevets

(11) Publication number: **0 511 555 A1**

# EUROPEAN PATENT APPLICATION

(21) Application number: **92106547.0**

(22) Date of filing: **15.04.92**

(51) Int. Cl.5: **H03H 9/64**, H03H 9/145

(30) Priority: **19.04.91 JP 88831/91**
**01.11.91 JP 287597/91**

(43) Date of publication of application:
**04.11.92 Bulletin 92/45**

(84) Designated Contracting States:
**DE FR GB SE**

(71) Applicant: **Oki Electric Industry Co., Ltd.**
**7-12, Toranomon 1-chome Minato-ku**
**Tokyo(JP)**

(72) Inventor: **Ou, Hokhuor, c/o Oki Electric**
**Ind.Co.,Ltd.**

**7-12, Toranomon 1-chome, Minato-ku**
**Tokyo(JP)**
Inventor: **Kasagi, Masakatsu, c/o Oki Electric**
**Ind.Co.,Ltd.**
**7-12, Toranomon 1-chome, Minato-ku**
**Tokyo(JP)**
Inventor: **Sakamoto, Nobuyoshi, c/o Oki**
**Electric Ind.Co.,Ltd.**
**7-12, Toranomon 1-chome, Minato-ku**
**Tokyo(JP)**

(74) Representative: **Betten & Resch**
**Reichenbachstrasse 19**
**W-8000 München 5(DE)**

(54) **High-power surface acoustic wave filter.**

(57) N² unit filters (N is an integer greater than one) are coupled to form a high-power filter system. The unit filters, which are all identical surface acoustic wave filters, are organized into N subsystems of N unit filters each. The unit filters and the subsystems they form are two-port networks that may be coupled together in either of two ways: in series, or in parallel. The subsystems are mutually coupled in one of these two ways. Within each subsystem, the unit filters are mutually coupled in the other way.

FIG. 3

▨ : TRANSMISSION-LINE
▧ : GROUND PATTERN

## BACKGROUND OF THE INVENTION

This invention relates to a surface acoustic wave filter, more particularly to a compact, high-power surface acoustic wave filter with good frequency characteristics.

Surface acoustic wave filters are widely used as bandpass filters in communications equipment and television receivers, to name just two applications, because of their excellent frequency characteristics, including high stopband rejection and flat in-band response. They also have high insertion loss, but this can be moderated by proper filter design or compensated by pre-amplification.

Surface acoustic wave filters have been limited to low-power applications, however. The limiting factor is migration of their aluminum interdigital electrodes: surface acoustic wave vibration causes particles of electrode material to shift in position, leading to contact between adjacent electrode fingers. Even if known migration countermeasures such as mixing copper or magnesium with the aluminum electrode material, optimizing the interdigital electrode structure, and attaching a heat sink to the filter package are taken, input power has been limited to about two watts. If input power is raised to three or four watts, the filter fails within the first few hours of operation.

## SUMMARY OF THE INVENTION

It is accordingly an object of the present invention to raise the input power ratings of surface acoustic wave filters.

Another object of the invention is to provide a high-power surface acoustic wave filter with good frequency characteristics.

The invented surface acoustic wave filter is an N x N filter system comprising a common input terminal, a common output terminal, and $N^2$ identical unit filters, where N is an integer greater than one. Each unit filter is a surface acoustic wave filter of, for example, the conventional type.

According to one aspect of the invention, the $N^2$ unit filters are organized as N filter subsystems, each comprising N unit filters coupled in series. The N Filter subsystems are themselves coupled in parallel between the common input terminal and the common output terminal.

According to another aspect of the invention, the $N^2$ unit filters are organized as N filter subsystems, each comprising N unit filters coupled in parallel. The N filter subsystems are themselves coupled in series to the common input terminal and the common output terminal.

## BRIEF DESCRIPTION OF THE DRAWINGS

Fig. 1 is a plan view of a unit filter.
Fig. 2 is a plan view of a series subsystem.
Fig. 3 is a plan view of a 2 x 2 series-parallel filter system.
Fig. 4 is a plan view illustrating the mounting of the filter system in Fig. 3 in a package.
Fig. 5 is a plan view of a series subsystem in which the unit filters are separated by a groove.
Fig. 6 is a schematic drawing showing N unit filters or subsystems coupled in series.
Fig. 7 is a schematic drawing showing N unit filters or subsystems coupled in parallel.
Fig. 8 is a schematic drawing showing a 2 x 2 series-parallel filter system.
Fig. 9 is a schematic drawing showing a 2 x 2 parallel-series filter system.
Fig. 10 is a schematic drawing for explaining the chain matrix.

## DETAILED DESCRIPTION OF THE INVENTION

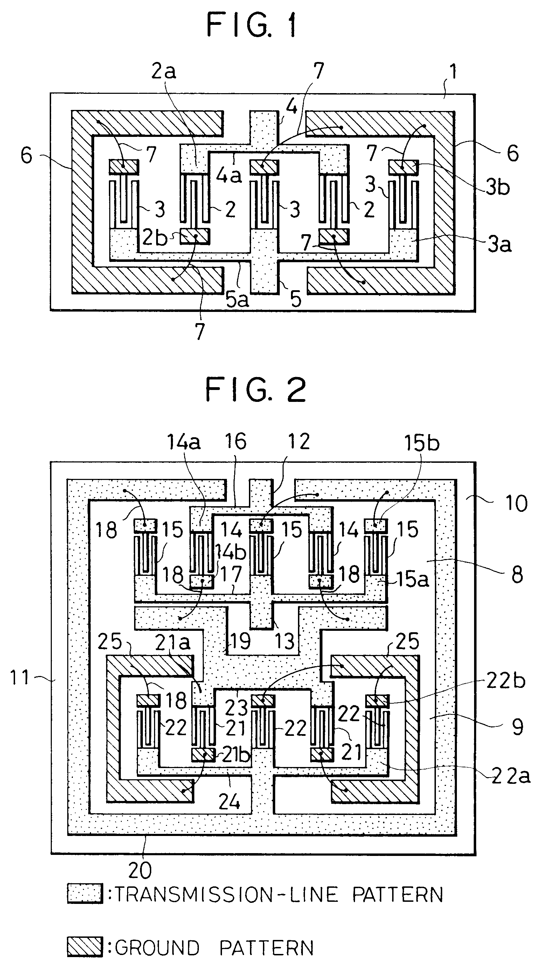

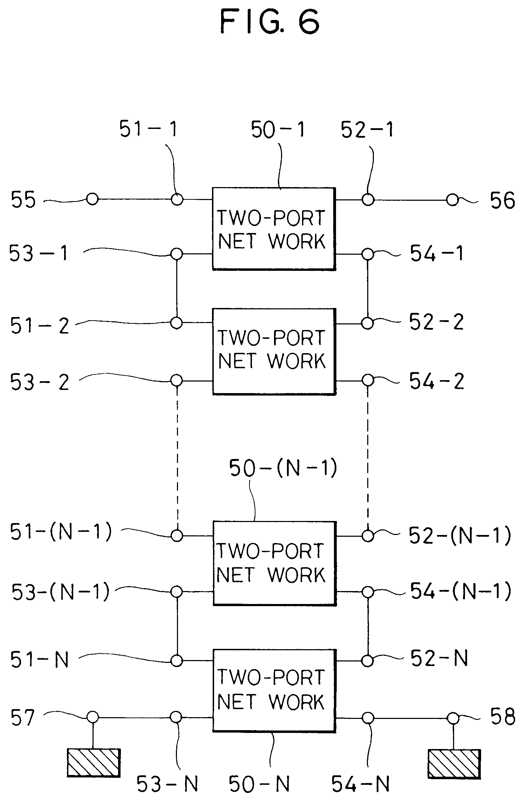

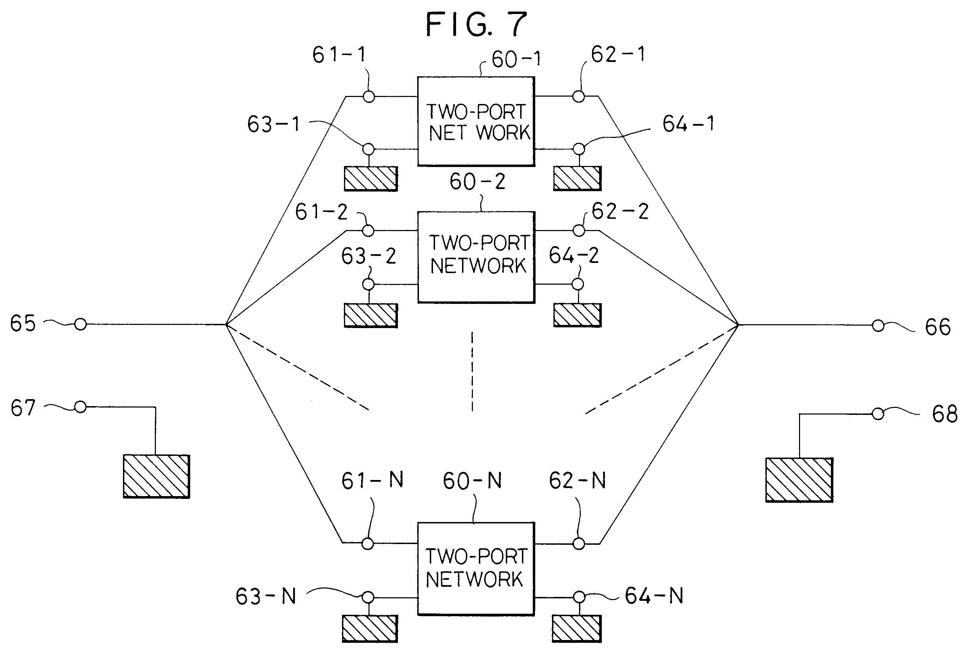

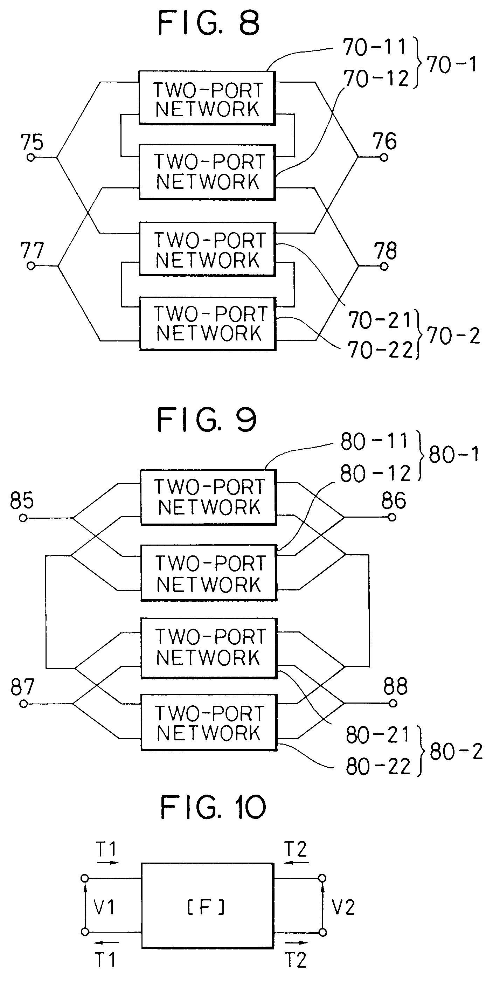

As an illustration of the invention, a 2 x 2 series-parallel filter system will be described with reference to Figs. 1 to 5. The general case of an N x N series-parallel or parallel-series filter system will then be described with reference to Figs. 6 and 7. The manner of connecting the unit filters in a 2 x 2 series-parallel filter system and in a 2 x 2 parallel-series filter system will then be described with reference to Figs. 8 and 9. Finally, it will be shown theoretically that the filter system has the same frequency characteristics as each of its constituent unit filters, with reference to Fig. 10.

Referring to Fig. 1, a conventional surface acoustic wave filter comprises a piezoelectric substrate 1 on which are formed two transmitting transducers 2 and three receiving transducers 3. An input terminal 4 is coupled to the transmitting transducers 2 by a transmission-line pattern 4a. An output terminal 5 is coupled to the receiving transducers 3 by a transmission-line pattern 5a.

The transmitting and receiving transducers 2 and 3 are of a well-known type comprising interdigital electrodes with a plurality of electrode fingers (only three electrode fingers are illustrated, but this is for simplicity of illustration: in a practical example, 21 electrode fingers are provided). Each of the transducers 2 comprises first and second terminal patterns 2a and 2b. The first terminal pattern 2a is continuous to and is electrically connected to the transmission pattern 4a. Each of the transducers 3 comprises first and second terminal patterns 3a and 3b. The first terminal pattern 3a is continuous to and is electrically connected to the transmission pattern 5a. The second terminal patterns 2b and 3b are coupled to a ground pattern 6 by a bonding wire 7.

Connected to the first terminal pattern 2a or 3a are a first group of electrode fingers (the two outer electrode fingers in the illustrated example). Connected to the second terminal pattern 2b or 3b are a second group of electrode fingers (the middle electrode finger in the illustrated example: although a single electrode finger is shown, the plural form "fingers" will be used throughout the specification in referring to the entire second group because a plurality of second group of electrode fingers are provided in most practical cases).

The piezoelectric substrate 1 comprises, for example, monocrystalline $LiTaO_3$, monocrystalline $LiNbO_3$, or multiple thin films of ZnO. The transmitting and receiving transducers 2 and 3 are made of aluminum, preferably with an admixture of a few percent of copper or magnesium to improve resistance to migration. The transmission-line patterns 4a and 5a, and the ground pattern 6, as well as the terminal patterns 2a and 3a and the terminal patterns 2b and 3b are are thin-film patterns of a substance such as gold.

Operation of the surface acoustic wave filter in Fig. 1 is well known from the prior art, so the description given here will be brief. The ground pattern 6 is held at a fixed ground or reference potential while a high-frequency electrical signal is applied to the input terminal 4, creating a high-frequency electric field in the transmitting transducers 2. The piezoelectric effect causes the transmitting transducers 2 to excite surface acoustic waves which propagate on the piezoelectric substrate 1 at right angles to the electrode fingers (in the horizontal direction in the drawing). When these surface acoustic waves encounter the receiving transducers 3, the piezoelectric effect causes a high-frequency voltage difference between the electrode fingers connected to the first and second terminal patterns 3a and 3b of the receiving transducers 3. With the electrode finger connected to the second terminal patterns 3b held at the ground potential, the result is a high-frequency output signal at the output terminal 5.

Excitation or detection of surface acoustic waves by the transmitting or receiving transducers 2 or 3 is efficient only at frequencies such that the surface acoustic waves excited or detected at the electrode fingers that are connected to the first and second terminal patterns 2a and 2b, or 3a and 3b reinforce each other. These frequencies are thus passed while other frequencies are rejected; the transducers act as a filter.

Fig. 2 shows two unit filters 8 and 9 of the type in Fig. 1 coupled in series to create a subsystem 10. Both unit filters are formed on the same piezoelectric substrate 11, which corresponds to the piezoelectric substrate 1 in Fig. 1. The subsystem 10 has a single input terminal 12 and a single output terminal 13.

The input terminal 12 and output terminal 13 are disposed in the upper unit filter 8, which comprises transmitting transducers 14 and receiving transducers 15. The input terminal 12 is coupled to the first terminal patterns 14a of the transmitting transducers 14 by a transmission-line pattern 16. The output terminal 13 is coupled to the first terminal patterns 15a of the receiving transducers 15 by a transmission-line pattern 17.

The second terminals 14b of the transmitting transducers 14 are coupled by bonding wires 18 to a transmission-line pattern 19. The second terminal patterns 15b of the receiving transducers 15 are coupled by bonding wires 18 to a transmission-line pattern 20.

The lower unit filter 9 comprises transmitting transducers 21 and receiving transducers 22. The electrode fingers connected to the first terminal patterns 21a of the transmitting transducers 21 are coupled by a transmission-line pattern 23 to the transmission-line pattern 19. The electrode fingers connected to the first terminal patterns 22a of the receiving transducers 22 are coupled by a transmission-line pattern 24 to the transmission-line pattern 20. The electrode fingers connected to the second terminal patterns 21b and 22b of the transmitting and receiving transducers 21 and 22 are coupled by bonding wires 18 to ground patterns 25.

Next the operation of the subsystem 10 will be described.

A high-frequency electrical input signal is applied to the input terminal 12 while the ground patterns 25 are held at a ground potential. The electrical input signal follows a path through the transmission-line pattern 16, transmitting transducers 14, bonding wires 18, transmission-line pattern 19, transmission-line pattern 23, transmitting transducers 21, and further bonding wires 18 to the ground patterns 25. The transmitting transducers 14 and 21 convert the electrical input signal to surface acoustic waves, which are then detected by the receiving transducers 15 and 22 and converted to electrical output signals.

3

The electrical output signals from the receiving transducers 22 in the lower unit filter 9 are merged and conducted by the transmission-line patterns 24 and 20 and bonding wires 18 to the second terminal patterns 15b of the receiving transducers 15 in the upper unit filter 8. Here they add to the voltage difference between the electrode fingers respectively connected to the first and second terminal patterns 15a and 15b in the receiving transducers 15 produced by surface acoustic waves received from the transmitting transducers 14. The resulting total electrical output signal is conducted by the transmission-line pattern 17 to the output terminal 13.

In considering the division of power, the transmitting transducers 14 and 21 may be regarded as electrical circuits which are identical to each other. These two identical circuits are connected in series between the input terminal 12 and ground patterns 25. By symmetry, the potential difference across the transmitting transducers 14 is equal to the potential difference across the transmitting transducers 21. Similarly, the receiving transducers 15 are coupled in series with the receiving transducer 22 between the output terminal 13 and the ground patterns 25, so the potential difference across the receiving transducers 15 is equal to the potential difference across the receiving transducers 22. It follows that the power input to the subsystem 10 is divided equally between the two unit filters 8 and 9.

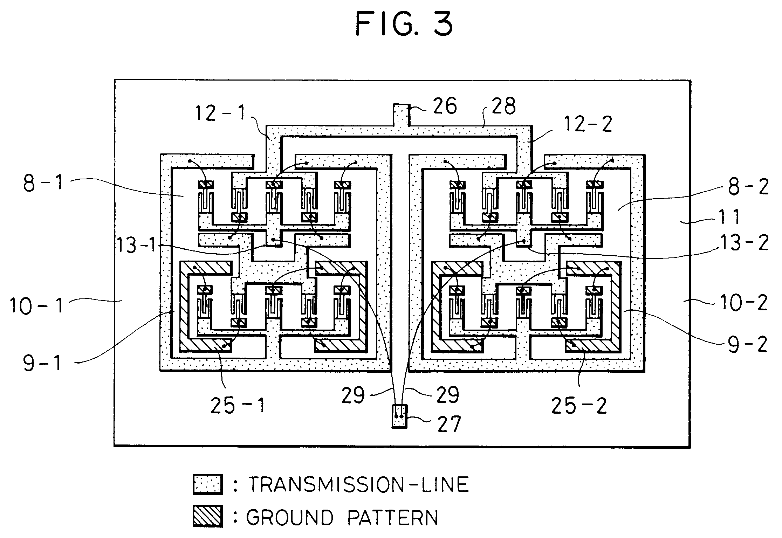

Fig. 3 shows a series-parallel surface acoustic wave filter system comprising two subsystems 10-1 and 10-2 both identical to the subsystem 10 in Fig. 2. The subsystem 10-1 comprises unit filters 8-1 and 9-1. The subsystem 10-2 comprises unit filters 8-2, and 9-2. Both subsystems 10-1 and 10-2 are formed on the same piezoelectric substrate 11.

The filter system in Fig. 3 has a common input terminal 26 and a common output terminal 27, as well as ground patterns 25-1 and 25-2 which are connected to each other by means not shown in Fig. 3. The common input terminal 26 is coupled to the input terminals 12-1 and 12-2 of the subsystems 10-1 and 10-2 by a transmission-line pattern 28 comprising, for example, a thin film of gold. The common output terminal 27 is coupled by bonding wires 29 to the output terminals 13-1 and 13-2 of the subsystems 10-1 and 10-2.

When a high-frequency input signal is applied to the common input terminal 26, filtering processes take place in the four unit filters 8-1, 9-1, 8-2, and 9-2 as already described, and an output signal is obtained at the common output terminal 27. By symmetry, the power of the input signal is divided equally between the two filter subsystems 10-1 and 10-2. Power is therefore divided equally among the four unit filters 8-1, 9-1, 8-2, and 9-2, each receiving substantially one-fourth of the total input power.

If the four unit filters 8-1, 9-1, 8-2, and 9-2 are each rated at two watts, for example, then the entire series-parallel filter system can easily operate at an input power level of three to four watts, since the individual unit filters need to withstand only 0.75 to one watt apiece. The maximum input power rating of the filter system in Fig. 3 is substantially four times as high as the power rating of its individual unit filters.

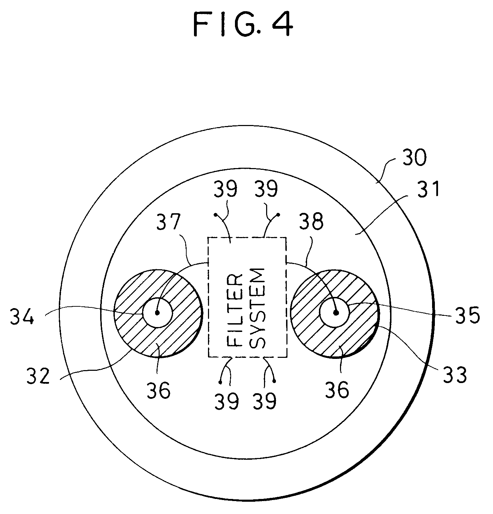

Referring to Fig. 4, the surface acoustic wave filter system in Fig. 3 is mounted in a package 30 having a stem 31 with through-holes 32 and 33. The stem 31 is made of a material such as iron, and is connected to an external ground terminal not shown in the drawing. A rod-like input terminal 34 and output terminal 35 pass through the centers of the through-holes 32 and 33, being isolated from the stem 31 by an insulating material 36 such as glass. The filter system in Fig. 3 is disposed between the input and output terminals 34 and 35 in Fig. 4.

The input terminal 34 is coupled by a bonding wire 37 to the input terminal of the filter system, that is, to the common input terminal 26 in Fig. 3. The output terminal 35 is coupled by a bonding wire 38 to the output terminal of the filter system, that is, to the common output terminal 27 in Fig. 3. The stem 31 is coupled by bonding wires 39 to the ground patterns in the filter system, that is, to the ground patterns 25-1 and 25-2 in the filter subsystems 10-1 and 10-2 of Fig. 3.

Since the entire filter system is integrated onto the same piezoelectric substrate 11 in Fig. 3 and housed in a single package 30 in Fig. 4, it takes up comparatively little space, despite its high power rating.

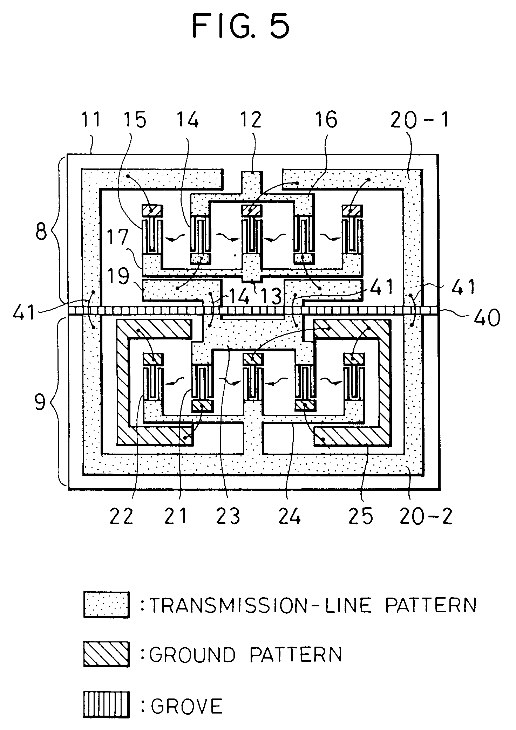

If mutual interference occurs between the two unit filters 8 and 9 in Fig. 2, they can be separated as shown in Fig. 5. Elements in Fig. 5 that are identical to elements in Fig. 2 have the same reference numerals. The only difference between Figs. 2 and 5 is that the upper unit filter 8 and lower unit filter 9 in Fig. 5 are separated by a groove 40 that blocks the propagation of surface acoustic waves. The groove 40 also divides the transmission-line pattern 20 into two parts 20-1 and 20-2, so these two parts are coupled by bonding wires 41 passing over the groove 40. The transmission-line pattern 19 is likewise coupled to the transmission-line pattern 23 by bonding wires 41.

A similar groove can be used to separate the filter subsystem 10-1 in Fig. 3 from the filter subsystem 10-2. By eliminating interference between different unit filters and subsystems, such grooves tend to improve the frequency characteristics of the filter system, particularly when the unit filters are disposed close to one another. The farther apart the unit filters are, the less necessary such grooves become. Instead of a groove, other surface acoustic wave blocking means can be used.

Next the case of an N x N filter system will be described.

The unit filter in Fig. 1 can be considered as a two-port electric network having an input port and an output port. The input port comprises the input terminal 4, which is coupled to the first terminal patterns 2a of the transmitting transducers 2, and an input ground terminal, to which the second terminal patterns 2b of the transmitting transducers 2 are coupled. The output port comprises an output terminal 5, which is coupled to the first terminal patterns 3a of the receiving transducers 3, and an output ground terminal, to which the second terminal patterns 3b of the receiving transducers 3 are coupled.

In Fig. 1 the input and output ground terminals both comprise the same ground patterns 6, but in the upper unit filter 8 in Fig. 2, for example, they become physically distinct: the input ground terminal of the unit filter 8 is the transmission-line pattern 19; the output ground terminal of the unit filter 8 is the transmission-line pattern 20.

In Fig. 6, N two-port networks 50-1, 50-2, ..., 50-N are coupled to form a single series network. The i-th two-port network (i = 1, 2, ..., N) has a first input terminal 51-i, a first output terminal 52-i, a second input terminal 53-i (which would be connected to the ground if the unit filter were used without being connected in series with other unit filters), and a second output terminal 54-i (which would also be connected to the ground if the unit filter were used without being connected in series with other unit filters). The entire series network is itself a two-port network with an input terminal 55, an output terminal 56, and input ground terminal 57, and an output ground terminal 58.

The first input terminal 51-1 of the first two-port network 50-1 is coupled to the input terminal 55 of the series network. The first output terminal 52-1 of the first two-port network 50-1 is coupled to the output terminal 56 of the series network. The second input terminal 51-N of the Nth two-port network 50-N is coupled to the input ground terminal 57 of the series network. The second output terminal 54-N of the Nth two-port network 50-N is coupled to the output ground terminal 58 of the series network.

The second input and second output terminals 53-1 and 54-1 of the first two-port network 50-1 are coupled to the first input and first output terminals 51-2 and 52-2, respectively, of the second two-port network 50-2. Similarly, the second input and second output terminals 53-2 and 54-2 of the second two-port network 50-2 are coupled to the first input and first output terminals of the next two-port network 50-3, and so on. The second input and second output terminals 53-(N-1) and 54-(N-1) of the (N-1)th two-port network 50-(N-1) are coupled to the first input and first output terminals 51-N and 52-N of the Nth two-port network 50-N.

The interconnection scheme in Fig. 6 can be more succinctly described by saying that the input ports of the two-port networks 50-1, ..., 50-N are coupled in series between the input terminal 55 and input ground terminal 57 of the series network, and the output ports of the two-port networks 50-1, ..., 50-N are coupled in series between the output terminal 56 and output ground terminal 58 of the series network.

It can be seen that Fig. 2 corresponds to Fig. 6 for the case N = 2.

In Fig. 7, N two-port networks 60-1, ..., 60-N are coupled in parallel to form a parallel network. The i-th two-port network (i = 1, 2, ..., N) has a first input terminal 61-i, a first output terminal 62-i, a second input terminal 63-i, and a second output terminal 64-i. The entire parallel network is itself a two-port network with an input terminal 65, an output terminal 66, and input ground terminal 67, and an output ground terminal 68.

The first input terminals 61-1, ..., 61-N of the two-port networks 60-1, ..., 60-N are all coupled to the input terminal 65 of the parallel network, their first output terminals 62-1, ..., 62-N are all coupled to the output terminal of the parallel network, their second input terminals 63-1, ..., 63-N are all coupled to the input ground terminal 67 of the parallel network, and their second output terminals 64-1, ..., 64-N are all coupled to the output ground terminal 68 of the parallel network. This interconnection scheme can be described simply by saying that the two-port networks 60-1, ..., 60-N are connected in parallel between the input and output ports of the overall parallel network.

If each of the two-port networks 60-1, ..., 60-N in Fig. 7 is identical to the entire series network in Fig. 6, the result is a series-parallel network. It can be seen that the system shown in the plan view of Fig. 3 is such a series-parallel network for the case N = 2. This series-parallel network for the case N = 2 can also be illustrated as shown in Fig. 8, in schematic representation. In Fig. 8, four two-port networks 70-11, 70-12, 70-21 and 70-22 respectively correspond to the unit filters 8-1, 9-1, 8-2 and 9-2 in Fig. 3, and the input terminal 75, the input ground terminal 77, the output terminal 76, and the output ground terminal 78 respectively correspond to the input terminal 26, both of the ground patterns 25-1 and 25-2, the output terminal 27 and both of the ground patterns 25-1 and 25-2 in Fig. 3. The two-port networks 70-11 and 70-12 are connected in series between the input terminal 75 and the input ground terminal 77, and the output terminal 76 and the output ground terminal 78, to form a series network or subsystem 70-1 which corresponds to the subsystem 10-1. The two-port networks 70-21 and 70-22 are connected in series between the input terminal 75 and the input ground terminal 77, and the output terminal 76 and the output ground terminal 78, to form a series network or subsystem 70-2 which correspond to the subsystem 10-2. The series networks 70-1 and 70-2 are connected in parallel to form the 2 x 2 series-parallel filter system having the input port 75 and 77 and the output port 76 and 78.

This scheme can be used to obtain an N x N series-parallel surface acoustic wave filter system comprising $N^2$ identical unit filters organized into N subsystems. Each subsystem comprises N unit filters of the type shown in Fig. 1, for example, coupled in series as shown in Fig. 6. The N subsystems are coupled in parallel as shown in Fig. 7.

The reverse scheme can be used to obtain an N x N parallel-series surface acoustic wave filter system. Once again there are $N^2$ unit filters organized into N subsystems. Each subsystem comprises N unit filters coupled in parallel as shown in Fig. 7. The N subsystems are coupled in series as shown in Fig. 6.

Such a parallel-series network for the case N = 2 is shown in Fig. 9. In Fig. 9, each of four two-port networks 80-11, 80-12, 80-21 and 80-22 comprises a unit filter. The two-port networks 80-11 and 80-12 are connected in parallel between an input port comprising terminals 85 and 87 and an output port comprising terminals 86 and 88, to form a parallel network or subsystem 80-1. The two-port networks 80-21 and 80-22 are connected in parallel between the input port 85 and 87 and the output port 86 and 88, to form a parallel network or subsystem 80-2. The parallel networks 80-1 and 80-2 are connected in series to form the 2 x 2 parallel-series filter system having the input port comprising terminals 85 and 87 and the output port comprising terminals 86 and 88.

The power rating of such an N x N series-parallel or parallel-series filter system is substantially $N^2$ times as high as the power rating of its constituent unit filters. Its frequency characteristics, however, are identical to those of a single unit filter. This will be shown next.

As is well known, the voltages and currents at the input and output ports, V1, V2, I1, and I2 of a two-port network, shown in Fig. 10, are related by a chain matrix (also called a transmission matrix) F as follows:

$$\begin{bmatrix} V1 \\ I1 \end{bmatrix} = [F] \begin{bmatrix} V2 \\ -I2 \end{bmatrix}$$

and [F] is defined by parameters A, B, C and D as follows:

$$[F] = \begin{bmatrix} A & B \\ C & D \end{bmatrix} \qquad (1)$$

A, B, C, and D are complex numbers (called chain parameters or transfer parameters) such that AD - BC = 1.

If N two-port networks with chain matrices F are coupled in series as in Fig. 6, the resulting series system is a two-port network with the following chain matrix:

$$[F_N] = \begin{bmatrix} A & NB \\ C/N & D \end{bmatrix} \qquad (2)$$

If the N two-port networks are coupled in parallel as in Fig. 7, the resulting parallel system is a two-port network with the following chain matrix:

$$[F_N] = \begin{bmatrix} A & B/N \\ NC & D \end{bmatrix} \qquad (3)$$

The N two-port networks must all be identical; otherwise current may flow between two of the networks, making formulas (2) and (3) invalid.

In the case of a series-parallel surface acoustic wave filter system as described above, each of the identical unit filters is a two-port network with a chain matrix [f]:

$$[f] = \begin{bmatrix} A & B \\ C & D \end{bmatrix} \qquad (4)$$

From formula (2), each subsystem of N unit filters coupled in series is a two-port network with the following chain matrix:

$$[f_N] = \begin{bmatrix} A_1 & B_1 \\ C_1 & D_1 \end{bmatrix} \qquad (5)$$

where

$A_1 = A$
$B_1 = NB \qquad (5-1)$
$C_1 = C/N$
$D_1 = D$

From formula (3), the chain matrix of the entire series-parallel system is as follows:

$$[F_N] = \begin{bmatrix} A_1 & B_1/N \\ NC_1 & D_1 \end{bmatrix} \qquad (6)$$

Substituting the above formulas (5-1) for $A_1$, $B_1$, $C_1$, and $D_1$ into formula (6) gives:

$$[F_N] = \begin{bmatrix} A & B \\ C & D \end{bmatrix} = [f] \qquad (7)$$

The chain matrix of total series-parallel surface acoustic wave filter system is identical to the chain matrix of each of its unit filters. Regardless of the value of N, the filter system therefore has the same transmission and impedance characteristics as a unit filter. The value of N can be raised to obtain high-power filters without risking degradation of these frequency characteristics, or degradation of insertion loss characteristics.

The case of a parallel-series surface acoustic wave filter system is similar. Each unit filter has the chain matrix given by formula (4). From formula (3), each subsystem of N unit filters coupled in parallel has the following chain matrix:

$$[f_N] = \begin{bmatrix} A_2 & B_2 \\ C_2 & D_2 \end{bmatrix} \qquad (8)$$

where

$A_2 = A$
$B_2 = B/N$  (8-1)
$C_2 = NC$
$D_2 = D$

From formula (2), the entire parallel-series filter system comprising N of these subsystems coupled in series has the following chain matrix:

$$[F_N] = \begin{bmatrix} A_2 & NB_2 \\ C_2/N & D_2 \end{bmatrix} \qquad (9)$$

Substituting the above formulas (8-1) for $A_2$, $B_2$, $C_2$, and $D_2$ into equation (9) gives:

$$[F_N] = \begin{bmatrix} A & B \\ C & D \end{bmatrix} = [f] \qquad (10)$$

The chain matrix of the total parallel-series surface acoustic wave filter system is again identical to the chain matrix of each of its unit filters, and its transmission and impedance characteristics are also identical.

Formulas (1) to (3) imply that if a filter system is configured simply by coupling N unit filters in series as in Fig. 6, or simply by coupling N unit filters in parallel as in Fig. 7, the characteristics of the system will differ from those of its unit filters. The difference will frequently be for the worse: insertion loss, for example, may become extremely high. This has been verified experimentally.

Those skilled in the art will realize that the novel filters described above can be modified in various ways. For example, the transducer geometry can be modified, and even the numbers of transmitting transducers and receiving transducers in each unit filter can be changed from two and three, respectively, to other numbers. The unit filters need not all be formed on the same piezoelectric substrate; a high-power N x N surface acoustic wave filter system can also be configured by coupling $N^2$ independently-packaged surface acoustic wave filters according to the scheme shown in Figs. 6 and 7. Alternatively, each of the subsystems comprising N unit filters may be formed on a single piezoelectric substrate and independently packaged, and N such subsystems formed on separate piezoelectric substrates and independently packaged may be electrically coupled together to form an N x N surface acoustic wave filter system. These and other modifications can be made without departing from the scope of the present invention.

**Claims**

**1.** An N x N series-parallel surface acoustic wave filter system, N being an integer greater than one, comprising:

a common input terminal;

a common output terminal; and

$N^2$ identical unit filters coupled between said common input terminal and said common output terminal, the unit filters being surface acoustic wave filters having respective input ports for receiving an electrical signal, transmitting transducers for converting said electrical signal to surface acoustic waves, receiving transducers for detecting said surface acoustic waves and producing an output signal, and output ports coupled to receive said output signal; wherein

said $N^2$ identical unit filters are organized into N subsystems of N unit filters each;

in each of said N subsystems, the input ports of said N unit filters are coupled in series, and the output ports of said N unit filters are coupled in series; and

said N subsystems are coupled in parallel between said common input terminal and said common output terminal.

8

2. The system of claim 1, wherein said transmitting transducers have interdigital electrodes, and said receiving transducers have interdigital electrodes.

3. The system of claim 1, wherein all of said $N^2$ identical unit filters are formed on a single piezoelectric substrate.

4. The system of claim 3, also comprising surface acoustic wave blocking means for blocking propagation of surface acoustic waves between different unit filters among said $N^2$ identical unit filters.

5. The system of claim 4, wherein said surface acoustic wave blocking means comprise one or more grooves in said piezoelectric substrate.

6. The system of claim 1, wherein all of said N unit filters in each of said N subsystems are formed on a common piezoelectric substrate, the unit filters of different subsystems are formed on separate piezoelectric substrates, and said N subsystems are electrically coupled to form the filter system.

7. The system of claim 6, also comprising surface acoustic wave blocking means for blocking propagation of surface acoustic waves between different unit filters among said $N^2$ identical unit filters.

8. The system of claim 7, wherein said surface acoustic wave blocking means comprise one ore more grooves in said piezoelectric substrate.

9. The system of claim 1, wherein all of said N identical unit filters are formed on separate piezoelectric substrates, are independently packaged, and are electrically coupled to form the filter system.

10. An N x N parallel-series surface acoustic wave filter system, N being an integer greater than one, comprising:
    a common input terminal;
    a common output terminal; and
    $N^2$ identical unit filters coupled between said common input terminal and said common output terminal, the unit filters being surface acoustic wave filters having respective input ports for receiving an electrical signal, transmitting transducers for converting said electrical signal to surface acoustic waves, receiving transducers for detecting said surface acoustic waves and producing an output signal, and output ports coupled to receive said output signal; wherein
    said $N^2$ identical unit filters are organized into N subsystems of N unit filters each, each of said N subsystems having a subsystem input port and a subsystem output port;
    in each of said N subsystems, said N unit filters are coupled in parallel between said subsystem input port and said subsystem output port; and
    subsystem input ports of said N subsystems are coupled in series to said common input terminal, and subsystem output ports of said N subsystems are coupled in series to said common output terminal.

11. The system of claim 9, wherein said transmitting transducers have interdigital electrodes, and said receiving transducers have interdigital electrodes.

12. The system of claim 9, wherein all of said $N^2$ identical unit filters are formed on a single piezoelectric substrate.

13. The system of claim 12, also comprising surface acoustic wave blocking means for blocking propagation of surface acoustic waves between different unit filters among said $N^2$ identical unit filters.

14. The system of claim 13, wherein said surface acoustic wave blocking means comprise one or more grooves in said piezoelectric substrate.

15. The system of claim 9, wherein all of said N unit filters in each of said N subsystems are formed on a common piezoelectric substrate, the unit filters of different subsystems are formed on separate piezoelectric substrates, and said N subsystems are electrically coupled to form the filter system.

16. The system of claim 15, also comprising surface acoustic wave blocking means for blocking propagation of surface acoustic waves between different unit filters among said $N^2$ identical unit filters.

17. The system of claim 16, wherein said surface acoustic wave blocking means comprise one or more grooves in said piezoelectric substrate.

18. The system of claim 9, wherein all of said N identical unit filters are formed on separate piezoelectric substrates, are independently packaged, and are electrically coupled to form the filter system.

# FIG. 1

# FIG. 2

▒▒▒ :TRANSMISSION-LINE PATTERN

▨▨▨ :GROUND PATTERN

# FIG. 3

☐ : TRANSMISSION-LINE

▨ : GROUND PATTERN

EP 0 511 555 A1

# FIG. 4

# FIG. 5

□ :TRANSMISSION-LINE PATTERN

▨ :GROUND PATTERN

▥ :GROVE

# FIG. 6

FIG. 7

# FIG. 8

TWO-PORT NETWORK

70-11
70-12 } 70-1

TWO-PORT NETWORK

75

76

TWO-PORT NETWORK

77

78

TWO-PORT NETWORK

70-21
70-22 } 70-2

# FIG. 9

TWO-PORT NETWORK

80-11
80-12 } 80-1

85

86

TWO-PORT NETWORK

TWO-PORT NETWORK

87

88

TWO-PORT NETWORK

80-21
80-22 } 80-2

# FIG. 10

T1

T2

V1

[ F ]

V2

T1

T2

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | GB-A-2 117 992 (PHILIPS) <br> * page 1, line 1 - line 12 * <br> * page 1, line 35 - page 2, line 39 * <br> * page 3, line 31 - line 69 * <br> * page 5, line 105 - line 127; figures 1,2 * | 1-3 | H03H9/64 <br> H03H9/145 |
| Y | | 4,5 | |
| A | | 10 | |
| | --- | | |
| A | EP-A-0 196 770 (OKI ELECTRIC INDUSTRY COMPANY) <br> * abstract; figure 5 * | 1,10 | |
| | --- | | |
| Y | PATENT ABSTRACTS OF JAPAN <br> vol. 006, no. 140 (E-121)29 July 1982 <br> & JP-A-57 063 921 ( TOSHIBA ) 17 April 1982 <br> * abstract * | 4,5 | |
| | ----- | | |
| | | | **TECHNICAL FIELDS SEARCHED (Int. Cl.5)** |
| | | | H03H |

The present search report has been drawn up for all claims

| Place of search | Date of completion of the search | Examiner |
|---|---|---|
| THE HAGUE | 25 AUGUST 1992 | WRIGHT J.P. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)